(19) Europäisches Patentamt
European Patent Office
Office européen des brevets

(11) **EP 4 664 083 A1**

(12) **EUROPEAN PATENT APPLICATION**

(43) Date of publication:
**17.12.2025 Bulletin 2025/51**

(21) Application number: **25181368.9**

(22) Date of filing: **06.06.2025**

(51) International Patent Classification (IPC):
*G01J 5/12* *(2006.01)*

(52) Cooperative Patent Classification (CPC):
**G01J 5/12**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **10.06.2024  DE 102024001975**

(71) Applicant: **Universität Hamburg**
**20148 Hamburg (DE)**

(72) Inventors:
• **Zierold, Robert**
**21107 Hamburg (DE)**
• **Peng, Jun**
**22607 Hamburg (DE)**
• **Blick, Robert**
**22763 Hamburg (DE)**

(74) Representative: **RGTH**
**Patentanwälte PartGmbB**
**Neuer Wall 10**
**20354 Hamburg (DE)**

(54) **THERMOELECTRIC DETECTOR**

(57)     The present invention provides a position-sensitive detector derived from heat transfer principles and thermoelectric effect, that detects the position of a single heat spot on the detection surface precisely. In more detail, the invention provides a thermoelectric detector, comprising: a substrate, being electrically insulating least on a surface; a thermoelectric film applied or deposited to the substrate; a first metallic contact on a first side of the thermoelectric film; and a second metallic contact on a second side of the thermoelectric film, wherein the thermoelectric detector is configured to determine a position of a point heat source on the substrate by measuring an electrical potential difference between the first metallic contact and the second metallic contact. Also provided is an extension of the inventive position-sensitive detector to two dimensions, a method for measuring the position of a heat spot using said thermoelectric detector and a method for manufacturing said thermoelectric detector.

a)

Fig. 2

EP 4 664 083 A1

**Description**

The present invention is concerned with the field of position-sensitive detectors, in particular thermoelectric-based detectors and/or temperature sensors.

Position-sensitive detectors (PSDs) are devices that can determine the position of incident radiation or (quasi-) particles in a spatially sensitive manner. These devices serve as fundamental components in modern industry and science. They hold a significant prominence throughout numerous applications, such as motion tracking, 3D printing, robotics, machining, and (quasi-)particle detection. State-of-the-art PSDs are often based on the photoelectric effect in a semiconductor junction, offering near one-micron-level resolution. Following the existing main PSD design principles, they can be primarily classified into two groups. The first category involves the lateral photoelectric effect on an isotropic sensor surface, supplying continuous position data. Typical representatives of this design are lateral PSD and quadrant PSD. They detect the light spot position by estimating the photocurrents measured by several electrodes. Such PSDs are widely used in ranging systems or high-precision instruments, etc. The second principle is to integrate discrete detection units together as a PSD to extract position information via pixel imaging, albeit at an expensive cost and inevitably sacrificing resolution. In the consumer market, for instance, complementary metal-oxide-semiconductors (CMOS) chips incorporate millions of small discrete pixels, so-called PIN diodes, as detection units to determine the light position.

However, these detectors, relying on silicon-based materials, impose strict requirements, i.e., limited operating temperature range and wavelength detection range. Other more complex discrete PSDs, e.g., thermopile array and bolometer arrays, can work in wider operating temperatures and spectral range, but still suffer from the complex fabrication process and low resolution.

Thus, there is a need in the art for a PSD which combines a decent spatial resolution with a wide frequency range.

This problem is solved by the present inventive concept for a PSD derived from heat transfer principles, that detects the position of a single heat spot (HS) on the detection surface precisely.

A detector utilizing this innovative concept is defined in claim 1.

A method for position-dependent temperature measurements using said innovative concept is defined in claim 9.

A method for fabricating a sensor according to the claimed invention is defined in claim 13.

Embodiments are defined by the dependent claims.

In more detail, the problem is solved by a thermoelectric detector, comprising: a substrate, being electrically insulating at least on a surface; a thermoelectric film applied or deposited to the substrate; a first metallic contact on a first side of the thermoelectric film; and a second metallic contact on a second side of the thermoelectric film, wherein the thermoelectric detector is configured to determine a position of a point heat source on the substrate by measuring an electrical potential difference between the first metallic contact and the second metallic contact.

In an embodiment, the substrate is planar and/or homogeneous and/or thermally conductive. This planar and/or homogeneous and/or thermally conductive substrate improves detection efficiency and simplifies the calculation of the detected heat source position.

In an embodiment, the thermoelectric detector further comprises a metallic ground contact which is applied to the thermoelectric film between the first metallic contact and the second metallic contact, wherein the metallic ground contact is grounded. This ground contact stabilizes the voltage measurement and centers the voltage range.

In an embodiment, the thermoelectric detector further comprises means for measuring a temperature, preferably a temperature-dependent resistor, at a point of the substrate, and/or the thermoelectric detector is configured to determine a temperature at a point of the substrate from a plurality of measured potential differences. This means that measuring a temperature allows for a measurement of not only the position of the heat spot, but also, by providing a temperature reference, of the temperature of the heat spot as well.

In an embodiment, the thermoelectric detector further comprises: a third metallic contact and a fourth metallic contact on a third side and on a fourth side of the thermoelectric film, and preferably further metallic contacts, preferably up to four further metallic contacts, particularly preferably evenly distributed over the surface of the substrate, wherein the thermoelectric detector is configured to determine a position of a point heat source on the substrate by measuring electrical potential differences between the metallic contacts. This setup with four, or, preferably up to eight, metallic contacts generalizes the detection of the heat spot position to two dimensions. Further contacts allow for more measurements, which can be used to compensate for inhomogeneities in the substrate.

In embodiments, the thermoelectric film is a) flat, or b) cross-shaped, or c) in the form of a polygon, preferably a rectangle, or d) applied to the substrate along, preferably four, edges. This patterning of the thermoelectric film can improve the homogeneity of the heat conduction, thus improving detector accuracy. Also, removing the thermoelectric film from the actual detection area prevents damage to the thermoelectric film when the heat spot is applied.

In embodiments, the substrate comprises or consists of at least one of the following materials: glass, silicon with an insulating layer, preferably of $SiO_2$ or $Si_3N_4$, aluminum with an insulating layer, preferably of $Al_2O_3$ or AlN, or copper with an insulating layer, preferably of $CuO$, $Cu_2O$ or $Cu_3N$, and/or the thermoelectric film comprises or is an aluminum-doped zinc oxide, AZO, film or a film of tellurium- and/or bismuth- and/or antimony- and/or selenium-containing and/or vanadium-containing material, and/or the thermoelectric film is structured by lithographic and etching processes, and/or the metallic contacts comprise titanium, copper, aluminum, platinum, chromium and/or gold, and/or consist of titanium, copper, aluminum, platinum, chromium. Thus, the material used for the inventive thermoelectric detector can be chosen from a wide range of materials depending on the application or cost considerations.

In an embodiment, the thermoelectric detector is configured to generate an electrical potential difference between the respective metallic contacts arranged on the sides of the thermoelectric film, utilizing the Seebeck effect when these metallic contacts have different temperatures. The use of the Seebeck effect for temperature sensing makes the thermoelectric detector suitable for heat spots of various different designs, e.g. laser, electron beam, or soldering iron.

The problem is further solved by a method for determining the position of a point heat source, preferably using a thermoelectric detector according to one of the previously described embodiments, the method comprising: measuring an electrical potential difference between a first metallic contact and a second metallic contact arranged on a thermoelectric film applied to a substrate electrically insulating at least at the surface; determining a position of a point heat source relative to the metallic contacts from the measured electrical potential difference by utilizing the Seebeck effect, in particular by utilizing the Seebeck coefficient of the thermoelectric film, and the thermal conductivity, in particular the thermal conductivity coefficient, of the substrate.

In an embodiment, the method further comprises: measuring electrical potential differences of the first and the second metallic contact with respect to a metallic ground contact applied to the thermoelectric film between the two metallic contacts; determining the position and temperature of the point heat source from the measured potential differences, and/or determining, in particular measuring, the temperature of one point of the substrate, preferably by means of a temperature-dependent resistor, and determining the position and temperature of the point heat source from the measured potential differences and the determined, preferably measured, temperature of the one point of the substrate. Again, the measurement of a reference temperature allows for the detection of both the position and the temperature of the heat spot at the same time.

In an embodiment, the method further comprises: Measuring the electrical potential differences of a third, fourth and preferably further metallic contacts, wherein the first, second, third and fourth metallic contacts and, if present, the further metallic contacts are arranged, preferably uniformly, distributed on the thermoelectric film; determining a two-dimensional position of a point heat source relative to the metallic contacts from the measured electrical potential differences utilizing the Seebeck effect, in particular utilizing the Seebeck coefficient of the thermoelectric film, and utilizing the thermal conductivity, in particular utilizing the thermal conductivity coefficient, of the substrate. Again, the use of a dedicated ground contact stabilizes the measurement and centers the measured voltage range and the use of additional metallic contacts also allows for more measurements which can be used to compensate for inhomogeneities. In embodiments, the potential differences of the third and fourth metallic contacts comprise at least one value from the potential differences between the first and third metallic contacts; the second and third metallic contacts; the first and fourth metallic contacts; the second and fourth metallic contacts; and the third and fourth metallic contact, and the potential differences of the further metallic contacts include the potential differences of the further contacts among each other and/or the potential differences between one of the further metallic contacts and one of the first, second and third metallic contacts, or the potential differences of the respective contacts include the potential difference of the corresponding contact to the ground contact, if said ground contact is present and included in the measurement. The use of more contacts combinatorically increases the number of potential differences, which allows for a quick determination of the heat source position even with a comparatively rough measurement.

The problem is further solved by a method of manufacturing a detector according to one of the previously defined embodiments, comprising the steps of: depositing a thermoelectric film with Seebeck values of preferably between $\pm 10$ $\mu$V/K and $\pm 500$ $\mu$V/K, particularly preferably between $\pm 50$ $\mu$V/K and $\pm 200$ $\mu$V/K on a, preferably planar, substrate, preferably a wafer, wherein the substrate is electrically insulating and/or has an electrically insulating layer on the surface; patterning the thermoelectric film; and depositing metallic contacts on the thermoelectric film.

In an embodiment the patterning of the thermoelectric film comprises the creation of a strip, a square frame or a cross and wherein the deposition of the metallic contacts comprises the deposition of two metallic contacts on two sides, preferably end sides, of the strip, of four metallic contacts on four sides, preferably ends, of the cross or of four metallic contacts on four sides of the square frame and/or the deposition of further, up to a total of eight, metallic contacts.

In embodiments, the thickness of the substrate, preferably consisting of glass, silicon, aluminum or copper, is between 0.1 $\mu$m and 1 mm, preferably 0.1 mm to 0.6 mm, particularly preferably 0. 5 mm, and/or the thickness of the electrically insulating layer, preferably consisting of the oxide or nitride of the material of the substrate, is 10 nm to 1000 nm, preferably 50 nm to 300 nm, particularly preferably 200 nm, and/or the thickness of the thermoelectric film, preferably consisting of aluminum-doped zinc oxide, AZO, is 5 nm to 750 nm, preferably 10 nm to 90 nm, particularly preferably 30 nm, and/or wherein the metallic contacts, preferably contain titanium, copper, aluminum, platinum, chromium and/or gold.

In an embodiment, the method of manufacturing the detector further comprises: applying a metallic ground contact to the thermoelectric film and connecting the ground contact to a ground line and/or applying a thermoelectric resistor to the substrate and/or to the thermoelectric film.

Aspects and advantages of the present invention are further exemplified with reference to the Figures. Herein depicts:

| | |
|---|---|
| Fig. 1a: | The principle of a conventional photodiode according to the state of the art. |
| Fig. 1b: | The principle of the inventive photodetector based on microscopic heat conduction. |
| Fig. 2a: | A schematic of a one-dimensional thermoelectric-based position-sensitive detector (1D T-PSD) according to an embodiment of the present invention. |
| Fig. 2b: | A simulation of a temperature distribution on the detector of Fig. 2a illuminated by a laser and the same temperature distribution projected on the length axis of the detector. |
| Fig. 2c: | A plot of the temperature differences between the ends of the sensor of Fig. 1a as a function of the laser spot position. |
| Fig. 2d: | A plot of the time-dependent voltage between the ends of the detector for different laser pulse lengths. |
| Fig. 2e: | A plot of the time-dependent voltage between the ends of the detector for different laser positions. |
| Fig. 2f: | A plot of the voltage between the ends of the detector as a function of laser position and laser pulse width. |
| Fig. 3a: | A schematic of a two-dimensional thermoelectric-based position-sensitive detector (2D T-PSD) according to an embodiment of the present invention. |
| Fig. 3b: | A simulation of a temperature distribution on the detector of Fig. 3a illuminated by a laser. |
| Fig. 3c: | A 2D T-PSD prototype according to an embodiment of the present invention. |
| Fig. 3d: | Voltage differences between terminal $V_1$ and ground terminal as a function of laser position. |
| Fig. 3e: | Voltage differences between terminal $V_2$ and ground terminal as a function of laser position. |
| Fig. 3f: | Voltage differences between terminal $V_3$ and ground terminal as a function of laser position. |
| Fig. 4a: | Laser HS pulses setup. The laser spot is located at the position (6, -2) and a varying PWM values of 4, 6, 8, 10, and 12% are used. |
| Fig. 4b: | Measured voltages at the terminals $V_i$ (i = 1, 2, 3) according to the laser pulses of Fig.4a. |
| Fig. 4c: | Ratios $R_a$ and $R_b$ derived from the measured voltages $V_i$. |
| Fig. 4d: | Contour plot for calculated ratios $R_a$ and $R_b$ as a function of laser position. |
| Fig. 4e: | Laser positions (circles) compared to corresponding reconstructed laser positions (crosses) using detected voltages. |
| Fig. 5: | A schematic of the different sectors for decoding the HS position according to an embodiment. |
| Fig. 6: | A schematic of the theoretical values of voltage ratios, $R_a$ (right) and $R_b$ (left) as a function of position according to an embodiment. |
| Fig. 7 a-c: | Three schematics for 2D T-PSDs according to embodiments of the invention. |
| Fig. 8 a-b: | Two more schematics 2D T-PSDs according to embodiments of the invention, involving a dedicated reference temperature electrode and eight electrodes for position and temperature of the point hot source detection. |
| Fig. 9 a-c: | Three schematics for 2D T-PSDs according to embodiments of the invention |
| Fig. 10 a-d: | Schematics for adding a dedicated electrode for reference temperature detection in 1D and 2D PSDs according to embodiments of the invention. |

Detailed description:

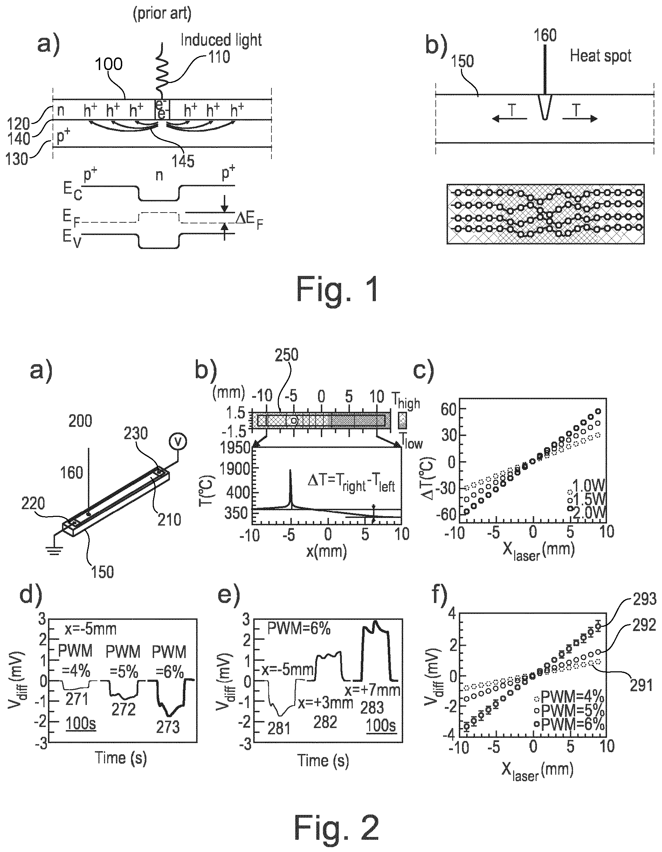

As described above, conventional position-sensitive detectors (PSDs), in particular photodetectors 100, as depicted in Fig. 1a, depend on the photoelectric effect 145 and are thus limited in their wavelength range since the energy of the incoming light 110 has to match the energy gap between bound valence electrons $E_v$ in and free electrons $E_F$ in the n-p transition layer 140.

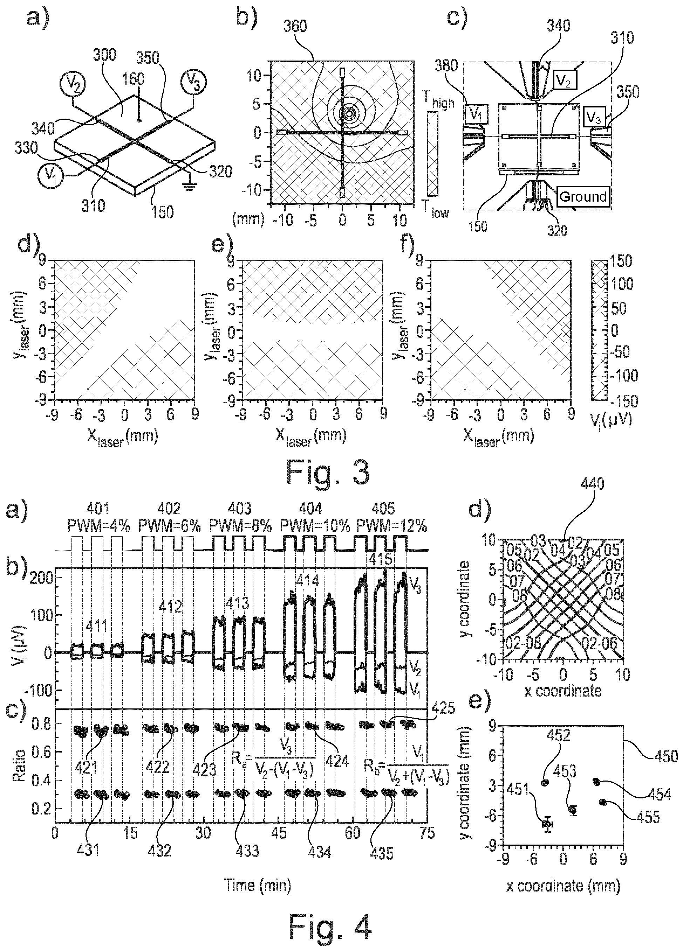

In contrast, the claimed position-sensitive detector (PSD), as shown in Fig. 1b, is derived from heat transfer principles and thermoelectric effect, and detects the position of a single heat spot (HS) 160 on the detection surface precisely. Preferably isotropic heat conduction on a preferably homogeneous substrate 150 results in a uniform temperature gradient distribution around a HS 160. Consequently, the HS 160 position on the surface of the substrate 150 can be determined based on the thermoelectric voltages generated from the temperature differences between HS 160 and pre-defined electrodes 220, 230, 320, 330, 340, 350. Based on this idea, the inventive detector may be realized in one-dimensional (1D) 200 and two-dimensional (2D) 300 devices, for single-point HS 160 detection, termed the thermoelectric-based PSD (T-PSD). These embodiments are further discussed with references to Figs 2a-f and 3a-f.

Since the arising thermoelectric voltages determine the signal strength, a thermoelectric thin film 210, 310 is incorporated into the detector design to amplify the measured signal. As the T-PSD relies on temperature differences for detection, it is capable of detecting HSs converted from various energy forms.

The inventive T-PSDs rely on the basic principles of heat transfer and the Seebeck effect, enabling accurate determination of a HS 160 on the detector surface. Assuming an ideal situation where only heat conduction is considered, a HS is introduced to an isotropic plate surface 150. On the one hand, energy is transferred from hotter regions near the HS 160 to those farther away and at lower temperatures. The temperature distribution on the plate is described by Fourier's law of heat conduction

$$(1)\ q_x = -kA\ dT/dx$$

Here, $q_x$ represents the rate of heat transfer, $k$ denotes the thermal conductivity, $A$ corresponds to the cross-sectional area through which the heat flows, and $dT/dx$ indicates the temperature gradient in the direction of the heat flow. On the other hand, a thermoelectric voltage arises when a temperature difference exists across two points within the plate, a phenomenon known as the Seebeck effect, expressed as

$$(2)\ S = -dV/dT$$

In the above equation, S is the Seebeck coefficient, while $dV$ represents the thermoelectric voltage arising from the temperature difference $dT$ between the two points. The relationship between $dV$ and $dx$ can be quantitatively concluded from equation (1) and equation (2) if $k$ and $S$ are independent of temperature. This relation builds the core principle of the inventive T-PSD, allowing precise derivation of the HS position on the detector surface. By appropriately extending Fourier's law, mathematical models for 1D and 2D T-PSDs can be derived.

For the substrate material, it is preferable, in addition to being thermally isotropic, to have a significant $S$ to make the detected thermoelectric signal more sensitive to a temperature change. Therefore, embodiments of the present invention involve using an isotropic substrate with a thermoelectric thin film on top.

In this way, $k$ and $S$ are mainly determined by the substrate and the thermoelectric thin film, respectively. In an embodiment, a silicon wafer with a 300 nm oxide insulating layer is used as the substrate, and an alumina-doped zinc oxide (AZO) film is selected to be the thermoelectric film. To minimize the potential contact thermal resistance between the substrate and the film, atomic layer deposition (ALD), established in the semiconductor industry, with its inherent conformal coating characteristic is chosen to deposit the thermoelectric film.

For theoretical simplicity, the theoretical model only considers the heat conduction within the substrate. Subsequent experimental validation proves the model's accuracy.

The 1D T-PSD design 200, depicted in Fig. 2a, consists of a preferably homogeneous substrate 210, a thermoelectric film on top, and two electrodes 220, 230 positioned at each end, of which one electrode 220 is preferably grounded. A HS 160 located at $x = x_0$ with a constant temperature $T = T_0$ leads to a thermoelectric voltage $V_{diff} = V_{right} - V_{left}$ between the two terminal electrodes, which can be expressed as

$$(3)\ V_{diff} = qS/kwd \cdot 2x_0.$$

Herein, q is the heat flux density (see equation 1) and S denotes the Seebeck coefficient (see equation 2) of the thermoelectric thin film. $k$, $w$, and $d$ correspond to the thermal conductivity, width, and thickness of the substrate, respectively. $x$ is the position of the HS.

As shown in Fig. 2b, upon introducing a HS 160, e.g., a laser beam as typically applied in laser cutting, to the sensor area 210, the temperature distribution 250 becomes uneven, resulting in a temperature difference, $\Delta T = T_{right} - T_{left}$, between the two terminals 220, 230.

As shown in Fig. 2c, the change in this $\Delta T$ is a power-dependent, linear function of the position. This change also results in a linear relationship between the corresponding measurable $V_{diff}$ and the position x. $V_{diff}$ is zero when the HS is at the center of the 1D T-PSD, i.e., x = 0. When the HS deviates in one direction from the center, it yields a signal of one polarity, while a signal of the opposite polarity is produced when the HS is displaced in the opposite direction. As a result, the 1D sensor 200 is capable of precisely detecting the center position of a HS by probing the null signal.

Fig. 2d and Fig. 2e show measured $V_{diff}$ showing a sensitive response to a $CO_2$ laser spot serving as a HS 160 on the sensing surface 210. The sensitivity is evident in the signal derived from the laser's different pulse width modulation (PWM) values 271, 272, 273 (Fig. 2d) and across various positions 281, 282, 283 (Fig. 2e). Herein, a smaller PWM in the $CO_2$ laser system corresponds to a lower laser power output, thus leading to actual lower temperatures on the T-PSD. The measured $V_{diff}$ exhibits a linear relationship 291, 292, 293 with the position on the T-PSD, as shown in Fig. 2f. The minor deviations in the central position at $V_{diff} = 0$ are primarily attributed to the influence of the temperature distribution of the imperfect geometry of the substrate. The measurements show a high reproducibility of these measurements for different PWM values, namely, 4%, 5%, and 6%, with corresponding central offsets of x = (-0.46 $\pm$ 0.03), (-0.47 $\pm$ 0.02) and (-0.50 $\pm$ 0.01) mm, respectively. These results indicate that the central position remains constant irrespective of the absolute temperature or fluctuation of the HS. This consistency aligns with the predictions made by the theoretical models.

The position sensitivity of the T-PSD is quantified by the slope of the line, expressed in units of V/mm:

$$(4)\ dV_{diff}/dx = -2qS/kwd.$$

The exemplary T-PSD has a positional sensitivity of 0.313 mV/mm at a PMW value of 6%. Based on the multimeter's resolution of 100 nV and the specific parameters of the materials used, the detection resolution for the HS's central position is estimated to be 0.319 $\mu$m. Herein, resolution may be further enhanced by employing a thermoelectric film with a higher $S$, a substrate with lower $k$, a thinner $d$, and a narrower w, as indicated by equation (4).

A distinct advantage of the inventive T-PSD is that it is not limited to the detection of laser beams but may also detect other heat sources like an electron beam or a hot soldering iron tip. A different substrate, glass, was used to fabricate another prototype, verifying that the T-PSD does not rely on a semiconducting substrate.

As shown in connection with Fig. 3a, the 1D T-PSD 200 can be expanded into a 2D T-PSD 300 by changing the geometry of the thermoelectric thin film from a strip 210 to a cross 310 and integrating two additional voltage-probe terminals 340, 350. A mathematical model for 2D T-PSD is derived by extending Fourier's law of heat conduction. The following set of equations express the probed thermoelectric voltage signals at the terminals 330, 340, 350:

$$V_1 = -\frac{qS}{4\pi kd}\ln\left(\frac{(x+L/2)^2+y^2}{x^2+(y+L/2)^2}\right)$$

$$(5)\ V_2 = -\frac{qS}{4\pi kd}\ln\left(\frac{x^2+(y-L/2)^2}{x^2+(y+L/2)^2}\right)$$

$$V_3 = -\frac{qS}{4\pi kd}\ln\left(\frac{(x-L/2)^2+y^2}{x^2+(y+L/2)^2}\right)$$

$V_1$, $V_2$ and $V_3$ represent the detected signals at the different electrodes 330, 340, 350 relative to the preferably grounded fourth electrode 320. $L$ is the side length of the square substrate 150. The corresponding position of the HS 160 is denoted by $(x, y)$. The magnitude of the probed voltage signals is determined by the coefficient, $-qS/4\pi kd$ which depends on the material properties and detector size, namely, $S$, $k$, and d as well as the heat flux $q$ generated from the HS 160. The signal distribution within the x-y coordinate system can thus be analyzed in a predictive manner.

As seen in Fig. 3b, a spatial temperature distribution 360 is observed when the sensor region 150 is exposed to a HS 160. Depending on the HS position, the temperatures of the different electrode terminals vary.

Fig. 3c shows a prototype 2D T-PSD device. The detection area of the sensor covers 18x18 mm$^2$. When a $CO_2$ laser beam, serving as a HS, is directed over the sensor's surface, it induces a localized temperature increase. This rise in temperature generates corresponding voltage signals at the different electrodes 320, 330, 330, 340. The experimental results shown in Fig. 3d-f align well with the mathematical and simulated distributions. A hot soldering iron tip and an electron beam can also be used as a HS to prove the versatility of the T-PSD in detecting diverse kinds of HSs, including, but not limited to, laser beams, electron beams, and ion beams, to name a few.

Further, and with reference to Figs. 4a-4c, the decoding of terminal 330, 340, 350 voltages into HS 160 positions is explained in more detail. The decoding process can be generally categorized into two levels: rough decoding and accurate decoding. On the one hand, the region where the HS is located on the T-PSD can be roughly determined from the combination of the positive and negative signs of the measured voltage signals $V_1$, $V_2$, and $V_3$. If any of the three signals equals zero, it indicates that the HS is located on the diagonals or $y = 0$ line. Additionally, the center of the 2D T-PSD 300 serves as a unique point because all signals are equal to zero. This feature can be used for precise centering scenarios.

On the other hand, accurate decoding can be achieved through a so-called ratio strategy. The coefficient, $-qS/4\pi kd$ in equation (5) affects the signal's amplitude, whereas the natural logarithm component governs the signal distribution and is only associated with the position $(x, y)$. The ratios, e.g. $V_1/V_2$, enable the elimination of the coefficients, making them independent of material properties and the local temperature rise due to the HS.

In an example, the following two ratios, $R_a$ and $R_b$, are selected for accurate decoding:

$$(6)\ \begin{aligned} R_a &= \frac{V_1}{V_2+(V_1-V_3)}\\ R_b &= \frac{V_3}{V_2-(V_1-V_3)} \end{aligned}.$$

The reliability of the "ratio strategy" is proven via a set of detected voltage signals at one position, i.e., (6, -2), under varying PWM values 401, 402, 403, 404, 105, as depicted in Fig. 4a-4b. As predicted, the two ratios 421-425, 431-435 are independent of the characteristics of the HS 160, converting a fluctuating signal output 411-415 into stable ratios 421-425, 431-435 for accurate decoding (Fig. 4c). Each position in the detection area corresponds to a unique ratio pair, indicating that precise position decoding is feasible, as it is obvious in the contour diagrams 440 of the two ratios (Fig. 4d).

To verify the reliability of the derived ratio strategy, several positions were randomly selected on the surface of the detector. The $CO_2$ laser beam was used as the HS for this experiment. The actual positions ((-3, -5), (-3, 1), (1, -3), (5, 1), (6, -2)) (circles) 451-455 and the decoded positions ((-2.66 ± 0.36, -5.13 ± 0.99), (-2.75 ± 0.36, 1.12 ± 0.38), (1.13 ± 0.28, -3.16 ± 0.53), (4.75 ± 0.15, 1.31 ± 0.18), (5.55 ± 0.11, -1.7 ± 0.12)) (crosses) 453-455 correspond well to each other, as shown in the Fig. 4e. Factors such as the detector's geometry, the air's convection, and the thermal radiation will be relatively weakened when the temperature is higher. The decoding is more accurate when the temperature rise induced by the laser's power is higher. The results of the conducted experiments demonstrate the reliability, consistency, and stability in detecting a HS 160 position using the 2D T-PSD 300.

An exemplary method for creating the thermoelectric detector (200; 300) is described in the following passages.

In an example, AZO films were deposited in a super-cycle ALD approach in exposure mode on $SiO_2$(300 nm)/Si wafers (SIEGERT WAFER GmbH) using a Savannah™100 reactor (Cambridge Nanotech). The deposition was performed at 200 °C with 30 sccm nitrogen as the carrier gas and a working pressure of ca. 1.5 Torr. The precursors, namely, deionized water (DIW), diethylzinc (DEZ, Strem Chemicals, Inc., USA), and trimethylaluminum (TMA, Strem Chemicals, Inc., USA), were used as the source of O, Zn, and Al, respectively. All precursors were contained in stainless-steel bottles and held at room temperature. An ALD super-cycle was set as [(DEZ-DIW)$_a$ + (TMA-DIW)$_b$ + (DEZ-DIW)$_c$]$_n$, to synthesize uniformly doped AZO film with a ratio of DEZ:TMA = (a+c):b = 20:1. The film thickness was adjusted to about 30 nm by running n = 30 super-cycles. Standard lithography processing was used to define the patterns, i.e., strip or cross for 1D and 2D, respectively, on the ALD-deposited AZO film. Next, diluted HCl solution (HCl: H20 = 2:100 v/v) was used to etch the film, leaving the desired pattern on the substrate. Subsequently, after removing the photoresist by acetone, another standard lithography process was used to define the electrode contact patterns, followed by sputtering Cr (10 nm) / Au (100 nm) as contacts.

The Seebeck coefficient of the AZO film was measured as -72 μV/K using a Potential-Seebeck microprobe (PSM II, PANCO GmbH). A laser micromachining system (MM200-Flex, OPTEC), whose machining resolution is smaller than 1 um, equipped with a $CO_2$ laser (48-2SWM, SYNRAD) was used to characterize the performance of our PSDs. The power output is 25 W with a wavelength of 10.2-10.8 um. PWM values of 4, 6, 8, 10, and 12% were used in the experiments. The average thermoelectric voltage signal from the PSD is measured using digital multimeters (34401 A, HEWLETT PACKARD HP) with an integration time of 1 s.

FEA conducted by COMSOL Multiphysics software was adapted to study the temperature and potential distribution on the T-PSD. The three-dimensional model was established using an almost one-to-one configuration (same size, same geometry) of the real T-PSDs. A gaussian beam profile was represented by the equation for the irradiance (intensity) distribution

$$(7)\ I(r) = \frac{P_{laser}}{2\pi r_{spot}^2} exp\left(-\frac{r_{focus}^2}{r_{spot}^2}\right)$$

where $P_{laser}$ is the laser power, $r_{spot}$ is the spot radius, and $r_{focus}$ is the radius of the laser at the focus point. The experimentally measured Seebeck coefficient was assigned to the AZO film. In contrast to analytical description, a surface-to-ambient radiation was set to 0.8.

Further details of the mathematical background are given as follows.

1D T-PSD theoretical framework

When a HS, e.g., a laser beam or a soldering iron tip, is present on the sensor surface, the heat transfer within the sensor can be described by Fourier's law of heat conduction. This fundamental law states that the rate of heat transfer through a solid is proportional to the temperature gradient, and can be mathematically expressed as

$$(8)\ q = -kA_{1D}\ dT/dx = -kwd \cdot dT/dx$$

where q is the heat flux density, $k$ is the material's thermal conductivity, and is considered a constant here, $A_{1D}$ is the area for the heat flow. To simplify the calculation, we neglected the thickness of the thermoelectric film as it is very thin (<100 nm). So, the $A_{1D}$ is the cross-section area of the substrate along the x-axis, i.e., $A_{1D} = wd$, where w and d are the width and thickness of the substrate, respectively. *dT/dx* is the temperature gradient, i.e., the change in temperature with respect to the distance in the direction of the heat flow. Herein, convection and radiation between the environment and the sensor were neglected, and only the lateral heat transfer within the substrate is considered. This equation shows that the temperature distribution in a 1D system with a constant HS is linearly proportional to the distance from the HS.

Combining equation (8) and the Seebeck effect expression, equation (2) yields

$$(9)\ dV/dx = qS/kA_{1D}.$$

Assuming a steady-state condition, where a HS with a constant temperature $T_0$ is located at $x = x_0$, the temperature distribution does not change with time. Two defined temperatures, $T_1$ and $T_2$, occur at the two ends of the sensor, i.e., at points $x(P_1) = -L/2$ and $x(P_2) = L/2$, respectively.

The thermoelectric voltage, $V_{\text{diff}}$ generated by the temperature difference can be described as

$$(10)\ V_{diff} = \frac{qS}{kA_{1D}}\left(\left(\frac{L}{2} + x_0\right) - \left(\frac{L}{2} - x_0\right)\right) = 2x_0\frac{qS}{kwd}.$$

Consequently, $V_{\text{diff}}$ reflects the position of the HS. This potential can be probed easily by a multimeter connected between the terminals.

2D T-PSD theoretical framework

Expanding the substrate of the 1D T-PSD and distancing the HS away from the thin thermoelectric film strip will lead to diminished accuracy in position detection. This reduction in sensitivity occurs because a variation in the distance between the electrodes at both ends is more sensitive to movements of the HS along the linear axis defined by the two probe electrodes, as opposed to movements perpendicular to this axis. To address this limitation, a cross-shaped thermoelectric film is introduced, transforming the 1D T-PSD into a 2D T-PSD. Ignoring the thickness of the thermoelectric film and the convection between the environment and the sensor as well as its own thermal radiation, only the lateral heat transfer is considered within the substrate. Furthermore, the 2D sensor is assumed to be an infinite 2D plate. Within this 2D space, the temperature distribution, as shown in Fig. 3b, is a function only of radial distance *r* between the point heat source $(x, y)$ and the probe points $(x_i, y_i)$, with $i = 1, 2, 3$, i.e., the metal contacts position, and is independent of azimuth angle when using the polar coordinates, which can be expressed as

$$(11)\ r = \sqrt{(x - x_i)^2 + (y - y_i)^2}.$$

Again, Fourier's law is used by inserting the proper area relation $A_r$, taking the substrate thickness *d* into account. The heat transfer can be considered as a radial transfer mode within a 2D plate. The area for the heat flow can be written as $A_r = 2\pi rd$. The radial heat flux $q_r$ from the HS is then written as

$$(12)\ q_r = -kA_r\frac{\partial T}{\partial r} = -2\pi krd\frac{\partial T}{\partial r},$$

with the boundary conditions $T = T_i$ at $r = r_i$, and the HS temperature $T = T_0$ at the HS edge $r = r_0$. The solution to the above equation is

$$(13)\ \bar{q} = -2\pi kd\frac{(T_i - T_0)}{ln(r_0/r)}.$$

Then temperature $T(x, y)$ at any point $(x, y)$ on the surface with a HS at position $(x_0, y_0)$ and a constant temperature $T_0$ can be expressed using the below equation

$$(14)\ T(x, y) = T_0 - \frac{\bar{q}}{2\pi kd}\ln\frac{r_0}{r}.$$

Where $r_0$ is the radius of the HS. According to equation (14), the temperature distribution is relatively insensitive to small variations in the value of $r_0$. The T-PSD detects the position but not the shape of the HS.

In the example of Fig. 3a, the 2D T-PSD has one ground terminal 320 and three probe terminals 330, 340, 350 at $P_1(-L/2, 0)$, $P_2(0, L/2)$, and $P_3(L/2,0)$, respectively. The temperature difference between the three points and the ground point $P_4(0, -L/2)$ can be written as

$$\Delta T_{1-4} = T_1 - T_4 = T\left(-\frac{L}{2}, 0\right) - T\left(0, -\frac{L}{2}\right) = \frac{q}{2\pi kd}\ln\frac{r_1}{r_4}$$

$$(15) \quad \Delta T_{2-4} = T_2 - T_4 = T\left(0, \frac{L}{2}\right) - T\left(0, -\frac{L}{2}\right) = \frac{q}{2\pi kd}\ln\frac{r_2}{r_4}$$

$$\Delta T_{3-4} = T_3 - T_4 = T\left(\frac{L}{2}, 0\right) - T\left(0, -\frac{L}{2}\right) = \frac{q}{2\pi kd}\ln\frac{r_3}{r_4}$$

Combining equation (11) and equation (15) yields

$$V_1 = -S\Delta T_{1-4} = -\frac{qS}{2\pi kd}\ln\frac{r_1}{r_4} = -\frac{qS}{4\pi kd}\ln\frac{(x+L/2)^2+(y)^2}{(x)^2+(y+L/2)^2}$$

$$(16)\ V_2 = -S\Delta T_{2-4} = -\frac{qS}{2\pi kd}\ln\frac{r_2}{r_4} = -\frac{qS}{4\pi kd}\ln\frac{(x)^2+(y-L/2)^2}{(x)^2+(y+L/2)^2}.$$

$$V_3 = -S\Delta T_{3-4} = -\frac{qS}{2\pi kd}\ln\frac{r_3}{r_4} = -\frac{qS}{4\pi kd}\ln\frac{(x-L/2)^2+(y)^2}{(x)^2+(y+L/2)^2}$$

T-PSD signals decoding

The probed voltage distributions (Fig. 3d-f,4) reveal three special lines, where $V_1$, $V_2$ and $V_3$ are equal to zero. In detail, when the HS is positioned on the x-axis, i.e., $y = 0$, $V_2 = 0$. Also, when the HS is located on the diagonal, i.e., $y = x$ or $y = -x$, the measured signal is $V_1 = 0$ or $V_3 = 0$, respectively. If at least one of the probed voltages is zero, then the HS is located on the x-axis, diagonals, or center point. However, one cannot derive the specific coordinate. Furthermore, these three lines divide the detection area into 6 sections as shown in Fig. 5. The signs of $V_1$, $V_2$ and $V_3$ vary among the six sectors, which can be used to locate the HS as outlined in the following table:

| Region/line | $V_1$ | $V_2$ | $V_3$ |
| --- | --- | --- | --- |
| $L_1$ | 0 | | |
| $L_2$ | | 0 | |
| $L_3$ | | | 0 |
| $A_1$ | + | + | - |
| $A_2$ | + | + | + |
| $A_3$ | - | + | + |
| $A_4$ | - | - | + |
| $A_5$ | - | - | - |
| $A_6$ | + | - | - |
| Center point | 0 | 0 | 0 |

For example, the signs of $V_1$, $V_2$ and $V_3$: from Fig. 4b are -, -, and +, respectively, indicating that the HS is situated in the A4 sector.

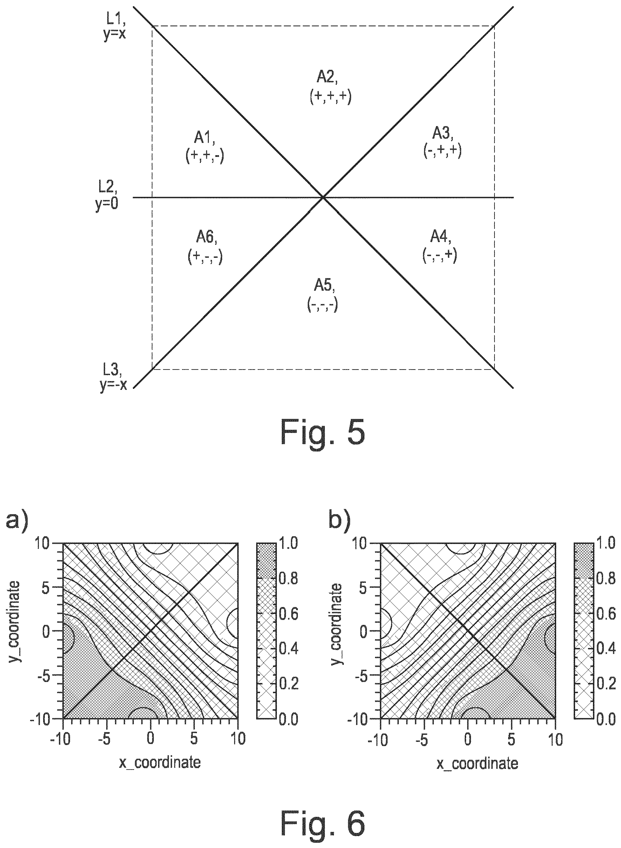

The temperature-related heat flow term, $q$, can be eliminated by dividing the theoretical voltage, which makes the defined ratio only position-dependent. Each coordinate $(x, y)$ has a set of calculated theoretical values, $R_a$ and $R_b$ as displayed in Fig. 6a and b. Therefore, the reference system can be used to calibrate the coordinates according to the ratio of the measured voltage signals. Generally speaking, DC voltage detection equipment hold uncertainties, which can greatly affect the decoding accuracy. Practically, it is necessary to measure the entire surface first to obtain the line segment with the measured value $V_i = 0$, ($i = 1, 2, 3$), and compare it with the corresponding line segment with the theoretical value $V_{i, theoretical} = 0$ to obtain the offset data $x_{offset}$ and $y_{offset}$. Then, the following formulas are used to correct the actual $x$ and $y$ in $V_1$, $V_2$ and $V_3$ in equation (5) and equation (6)

$$(17) \quad \begin{cases} x_{i,update} = x + x_{offset}, & (i = 1, 2, 3) \\ y_{i,update} = y + y_{offset}, & (i = 1, 2, 3) \end{cases}.$$

This equation group may contain multiple solutions, i.e., several coordinates: First, take the average of all the solutions in the intersection set as the true solution. Second, calculate the mean and standard error of $x$ and $y$, respectively, to get the coordinates $(\bar{x} \pm s_x, \bar{y} \pm s_y)$. These coordinates represent the actual location of the HS.

Further preferred embodiments

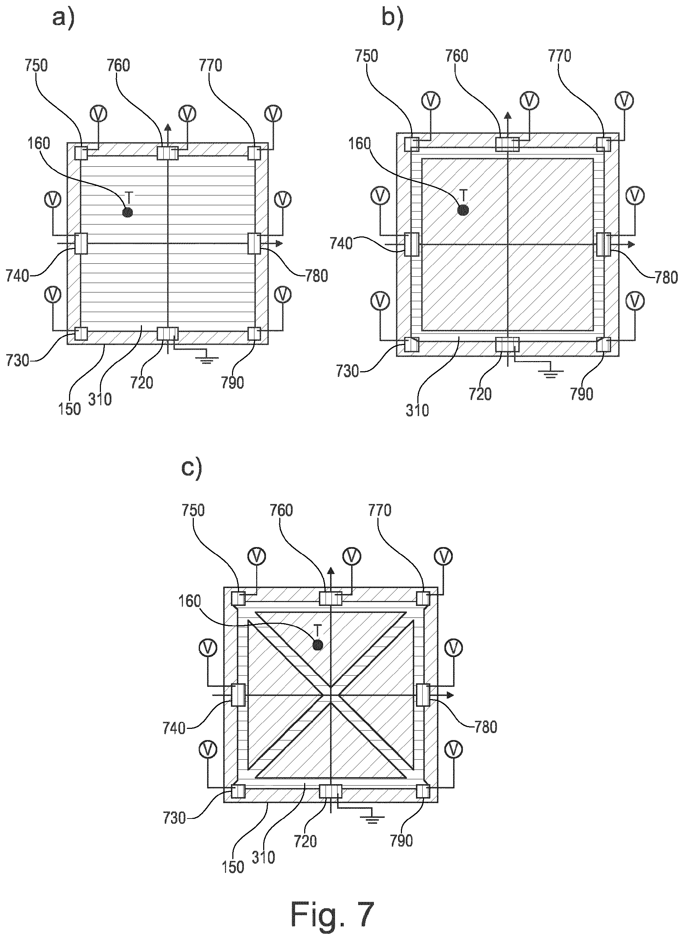

In the following, preferred embodiments of the invention are discussed with reference to Figures 7 to 10.

Fig. 7 shows three embodiments of the inventive 2D T-PSD for the detection of the position of a HS 160. Herein, the thermoelectric film 310 is applied or deposited to the substrate 150 and provided with electrodes 720-790 at the edges. Corresponding to different embodiments, the thermoelectric film is patterned in different ways from the cross shape shown in Fig. 3. In particular, the thermoelectric 310 film is planar in Fig. 7a, applied or deposited as a frame along the edges of the substrate 150 in Fig. 7b, and a combination of cross and frame shape in Fig. 7c.

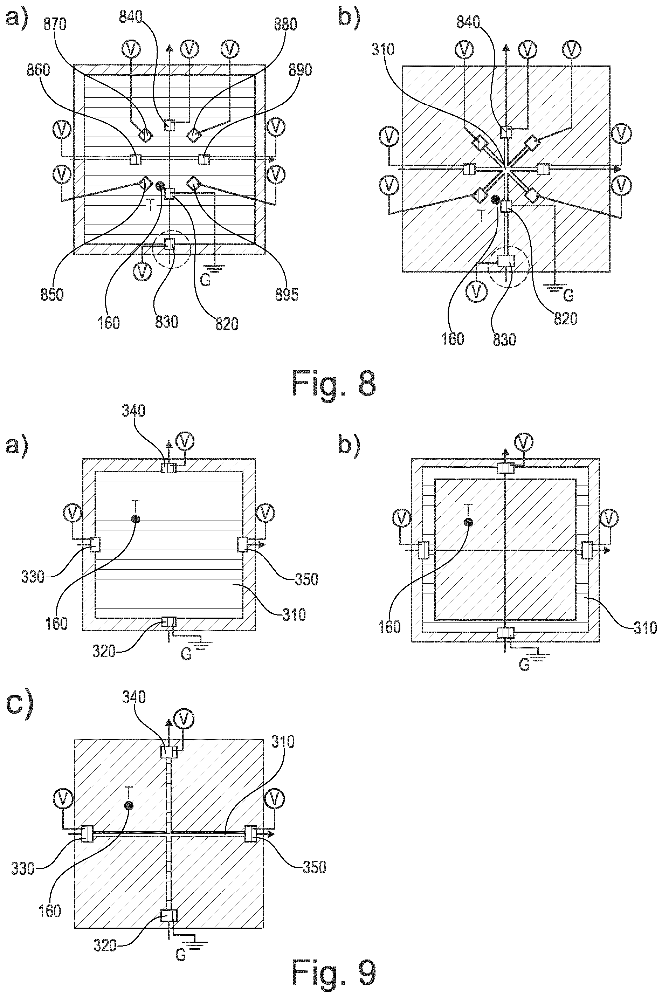

Fig. 8 shows two embodiments of the inventive 2D T-PSD in which a dedicated ground electrode 820 is applied or deposited between two of the electrodes 830 and 840. Again, different ways of patterning the thermoelectric film are depicted, namely a planar shape in Fig. 8a and an asterisk shape in Fig. 8b. However, the positioning of the ground electrode is not necessarily limited to these shapes.

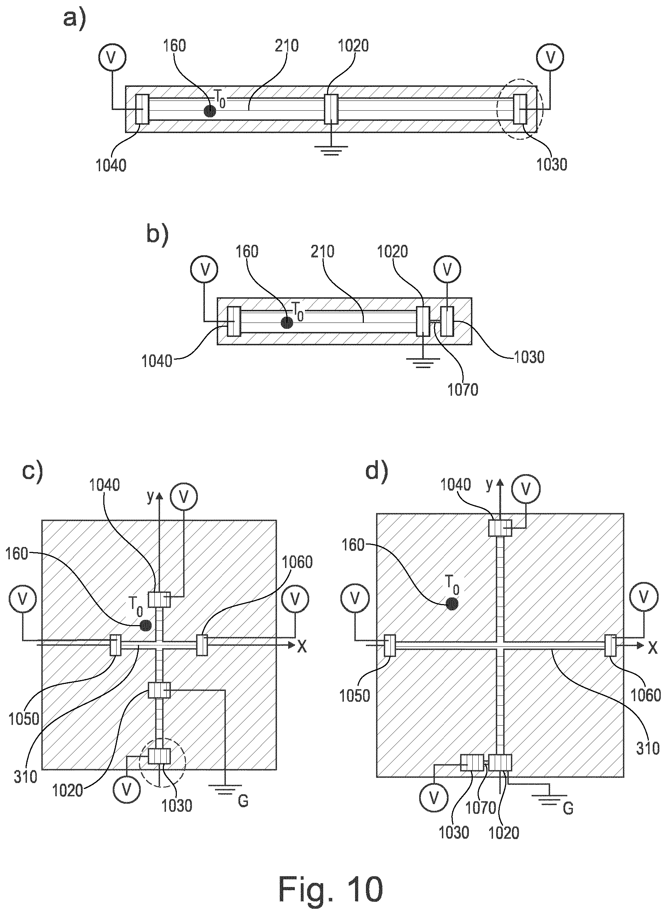

Fig. 9 shows three embodiments of the inventive 2D T-PSD in which, as in the embodiments of Fig. 3, one electrode 320 of four evenly distributed electrodes 320-340 is grounded. As shown in Figs 9a-c, this distribution of electrodes may be combined with different patterns of the thermoelectric film 310, for example planar as in Fig. 9a, in the form of a quadratic frame along the edges in Fig. 9b, or cross-shaped in Fig. 9c. Fig. 10a-d shows different embodiments of the inventive 1D and 2D T-PSDs, in which the ground electrode 1020 is placed between two of the electrodes 1030 and 1040. This can be done either by placing all three electrodes on the thermoelectric film 210, 310, as shown in Fig. 10a for the 1D T-PSD and in Fig. 10c for the 2D T-PSD or by ending the thermoelectric film 210, 310 at the ground electrode 1020 and connecting the measurement electrode 1030 to the ground electrode 1020 using a piece of conductor 1070, e.g. solder, wire, deposited metal, or other conductive material.

In addition, one of the electrodes, in particular the electrode 1030 furthest away from the center of the detection range can be replaced or supplemented by a thin film thermometer (dashed circle) for the measurement of a reference temperature.

The example for 1D T-PSD with at least one thin film metal thermometer for reference temperature measurement, as sketched in Fig. 10a, can measure the position and temperature of the HP between electrode 1020 and electrode 1040 at the same time. In the example, $T_f$, $T_1$ and $T_2$ are the temperatures at the right reference temperature position 1030 $x = -d_f$, ground electrode 1020 position $x = 0$ and left electrode 1040 position $x = L$, respectively. $d_f$ and $d_e$ are the distance of the ground electrode 1020 to the thin film metal thermometer 1030 and to the right substrate edge, respectively. $V_1$ and $V_2$ are the thermoelectric voltage between the ground electrode 1020 position and the reference temperature position 1030, and the ground electrode position 1020 and the left electrode position 1040. The position $x = x_0$ and temperature $T_0$ of the HP during the measurement can be derived from the known values of $T_f$, $V_1$, $V_2$, $d_e$, $d_f$ and $L$, as well as $k$, $w$, and $d$.

Various methods exist for measuring the reference temperature $T_f$ at a specific point. For example, in Fig. 10b, an approach that measures the resistivity of a thin film metal bar 1070, utilizing the temperature-dependent resistivity effect, can be used:

$$(18) \quad \rho = \rho_0 \left[ 1 + \alpha \left( T_f + T_{f,0} \right) \right].$$

Herein, $\rho$ the resistivity at a temperature $T_f$ during the measurement, $\rho_0$ is the resistivity at a reference temperature $T_{f,0}$ (usually taken to be 20°C), and $\alpha$ is the temperature coefficient of resistivity. The temperature relationships between the HP and three points, at right reference temperature position 1030 $x = -d_f$, ground electrode position 1020 $x = 0$, and left electrode position 1040 $x = L$, respectively, can be expressed by equation (1) or equation (8), wherein $q$ is

taken equal.

$$q = -kwd \frac{T_1 - T_f}{d_f}$$

$$(19)\ q = -kwd \frac{T_0 - T_f}{d_f + x_0}.$$

$$q = -kwd \frac{T_0 - T_2}{L - x_0}$$

According to equation (2), $V_1$ and $V_2$ can be expressed as:

$$(20)\ \begin{aligned} S &= -\frac{V_1}{T_1 - T_f} \\ S &= -\frac{V_2}{T_2 - T_f} \end{aligned}.$$

Combining these equations yields the position $x_0$ and temperature $T_0$ of the HP as

$$(21)\ x_0 = \frac{d_f V_2}{2V_1} + \frac{L - d_f}{2}; \ T_0 = T_f - \frac{V_2}{2S} - \frac{V_1}{2S d_f}\left(L + d_f\right).$$

Therefore, by adding a thermometer for reference temperature measurement, one can obtain the position $x = x_0$ and temperature $T_0$ information of the HP simultaneously during the measurement.

Similarly, the 2D TPSD can be used with at least one thin film metal thermometer for reference temperature measurement. In an example, the setup of Fig. 10d is used, wherein the thin bar 1070 between the ground electrode 1020 and the further electrode 1030 can serve as a temperature-dependent resistance as described above. This example extends the embodiment of Fig. 3 discussed in detail above with an additional temperature reference at the ground electrode $T_f = T_4$, and thus, with equations (14) and (16),

$$(22)\ T_4 = T_0 - \frac{q}{2\pi kd}\ln\frac{r_0}{r_4}, \ V_1 = -\frac{qS}{2\pi kd}\ln\frac{r_1}{r_4}$$

The heat flux $q$ can be eliminated and the HP temperature $T_0$ can be written as

$$(23)\ T_0 = T_f - \frac{V_1}{S}\frac{\ln\frac{r_0}{r_4}}{\ln\frac{r_1}{r_4}}.$$

## Claims

1. A thermoelectric detector (200; 300), comprising:

a substrate (150), being electrically insulating at least on the surface;
a thermoelectric film (210; 310) applied or deposited to the substrate;
a first metallic contact (220, 230; 320-350; 720-790; 810-895; 1020-1060) on a first side of the thermoelectric film; and
a second metallic contact (220, 230;320-350; 720-790; 820-895; 1020-1060) on a second side of the thermoelectric film,
**characterized in that**
the thermoelectric detector (200; 300) is configured to determine a position of a point heat source (160) on the substrate (150) by measuring an electrical potential difference, $V_{diff}$, between the first metallic contact (220, 230; 320-350; 720-790; 820-895; 1020-1060) and the second metallic contact (220, 230; 320-350; 720-790; 820-895; 1020-1060).

2. The thermoelectric detector (200; 300) according to claim 1, wherein the substrate (150) is planar and/or homogeneous and/or thermally conductive.

3. The thermoelectric detector (200; 300) according to claim 1 or 2, further comprising a metallic ground contact (220; 320; 720; 820; 1020) which is applied or deposited to the thermoelectric film (210; 310) between the first metallic contact ( 830; 1030) and the second metallic contact ( 840;1040), wherein the metallic ground contact (220; 320; 720; 820; 1020) is grounded.

4. The thermoelectric detector (200; 300) according to one of claims 1 to 3, further comprising means for measuring a temperature, preferably a temperature-dependent resistor (1070), at a point of the substrate and/or wherein the thermoelectric detector (200; 300) is configured to determine a temperature at a point of the substrate from a plurality of measured potential differences, $V_{diff}$.

5. The thermoelectric detector (200; 300) according to one of claims 1 to 4, further comprising:

   a third metallic contact (340; 740; 840; 1050) and a fourth metallic contact (350; 750; 860; 1060) on a third side and on a fourth side of the thermoelectric film (310), and preferably
   further metallic contacts (750-790; 850-895), preferably up to four further metallic contacts, particularly preferably evenly distributed over the surface of the substrate (150),
   **characterized in that**
   the thermoelectric detector (200; 300) is configured to determine a position of a point heat source (160) on the substrate (150) by measuring electrical potential differences, $V_{diff}$, between the metallic contacts (320-350; 720-790; 820-895; 1020-1060).

6. The thermoelectric detector (200; 300) according to claim 5, wherein the thermoelectric film (310) is

   a) flat, or
   b) cross-shaped, or
   c) in the form of a polygon, preferably a rectangle, or
   d) applied to the substrate (150) along, preferably four edges

7. The thermoelectric detector (200; 300) according to any one of the preceding claims,

   wherein the substrate (150) comprises or consists of at least one of the following materials:
   glass,
   silicon with an insulating layer, preferably of $SiO_2$ or $Si_3N_4$,
   aluminum with an insulating layer, preferably of $Al_2O_3$ or AlN, or
   copper with an insulating layer, preferably of CuO, $Cu_2O$ or $Cu_3N$, and/or
   wherein the thermoelectric film (210; 310) comprises or is an aluminum-doped zinc oxide, AZO, film or a film of tellurium- and/or bismuth- and/or antimony- and/or selenium- and/or vanadium- containing material, and/or
   wherein the thermoelectric film (210; 310) is structured by lithographic and etching processes, and/or
   wherein the metallic contacts (220, 230; 320-350; 720-790; 820-895; 1020-1060) comprise titanium, copper, aluminum, platinum, chromium and/or gold, and/or consist of titanium, copper, aluminum, platinum, chromium.

8. The thermoelectric detector (200; 300) according to one of the preceding claims, wherein the thermoelectric detector (200; 300) is configured to generate an electrical potential difference, $V_{diff}$, between the respective metallic contacts (220, 230; 320-350; 720-790; 820-895; 1020-1060) arranged on the sides of the thermoelectric film utilizing the Seebeck effect when these metallic contacts (220, 230; 320-350; 720-790; 820-895; 1020-1060) have different temperatures.

9. A method for determining the position of a point heat source (160), preferably using a thermoelectric detector (200; 300) according to any one of claims 1 to 8, the method comprising:

   measuring an electrical potential difference, $V_{diff}$, between a first metallic contact (220, 230; 320-350; 720-790; 820-895; 1020-1060) and a second metallic contact (220, 230; 320-350; 720-790; 820-895; 1020-1060) arranged on a thermoelectric film (220; 320) applied to a substrate (150), wherein the substrate (150) is electrically insulating at least at the surface;
   determining a position, x, of a point heat source (160) relative to the metallic contacts (220, 230; 320-350;

720-790; 820-895; 1020-1060) from the measured electrical potential difference by utilizing the Seebeck effect, in particular by utilizing the Seebeck coefficient of the thermoelectric film (220; 320), and the thermal conductivity, in particular the thermal conductivity coefficient, of the substrate (150).

10. The method according to claim 9, further comprising:

measuring electrical potential differences, $V_{diff}$, of the first and the second metallic contact (220, 230; 320-350; 720-790; 820-895; 1020-1060) with respect to a metallic ground contact (220; 320; 720; 820; 1020) applied to the thermoelectric film between the two metallic contacts;
determining the position, x, and temperature, $T_0$, of the point heat source (160) from the measured potential differences, $V_{diff}$, and/or
determining, in particular measuring, the temperature of one point of the substrate, preferably by means of a temperature-dependent resistor (1070), and determining the position and temperature of the point heat source (160) from the measured potential differences and the determined, preferably measured, temperature of the one point of the substrate (150).

11. The method according to claim 9 or 10, further comprising:

Measuring electrical potential differences, $V_i$, of a third, fourth and preferably further metallic contacts (320-350; 720-790; 820-895; 1020-1060), wherein the first, second, third and fourth metallic contacts and, if present, the further metallic contacts are arranged, preferably uniformly, distributed on the thermoelectric film;
determining a two-dimensional position, (x, y), of a point heat source (160) relative to the metallic contacts (320-350; 720-790; 820-895; 1020-1060) from the measured electrical potential differences, $V_i$, utilizing the Seebeck effect, in particular utilizing the Seebeck coefficient of the thermoelectric film (210; 310), and utilizing the thermal conductivity, in particular utilizing the thermal conductivity coefficient, of the substrate (150).

12. Method according to claim 11, wherein the potential differences, $V_i$, of the third and fourth metallic contacts (340, 350; 750; 850; 1050, 1060) comprise at least one value from the potential differences between

the first (320; 720; 820; 1030) and third (340; 740; 840; 1050) metallic contacts; the second (330; 730; 830; 1040) and third (340; 740; 840; 1050) metallic contacts;
the first (320; 720; 820; 1030) and fourth (350; 750; 850; 1060) metallic contacts; the second (330; 730; 830; 1040) and fourth (350; 750; 850; 1060) metallic contacts; and
the third (340; 740; 840; 1050) and fourth (350; 750; 850; 1060) metallic contact, and
wherein the potential differences of the further metallic contacts include the potential differences of the further contacts between each other and/or the potential differences between one of the further metallic contacts and one of the first, second and third metallic contacts, or
wherein the potential differences of the respective contacts include the potential difference of the respective contact to the ground contact (1020), if said ground contact is present and included in the measurement.

13. A method of manufacturing a detector according to any one of claims 1 to 8, comprising the steps of:

applying or depositing a thermoelectric film (210; 310) with Seebeck values of preferably between $\pm 10\,\mu V/K$ and $\pm 500\,\mu V/K$, particularly preferably between $\pm 50\,\mu V/K$ and $\pm 200\,\mu V/K$ on a, preferably planar, substrate (150), preferably a wafer, wherein the substrate (150) is electrically insulating and/or has an electrically insulating layer on the surface;
patterning the thermoelectric film (210; 310); and
depositing metallic contacts (220, 230; 320-350; 720-790; 820-895; 1020-1060) on the thermoelectric film.

14. The method according to claim 13, wherein the patterning of the thermoelectric film (210; 310) comprises the creation of a strip, a square frame or a cross and wherein the deposition of the metallic contacts (220, 230;320-350; 720-790; 820-895; 1020-1060) comprises the deposition of two metallic contacts on two sides, preferably end sides, of the strip, of four metallic contacts on four sides, preferably ends, of the cross or of four metallic contacts on four sides of the square frame and/or the deposition of further, up to a total of eight, metallic contacts.

15. The method according to claim 13 or 14, wherein

the thickness of the substrate (150), preferably consisting of glass, silicon, aluminum or copper, is between $0.1\,\mu m$

and 1 mm, preferably 0.1 mm to 0.6 mm, particularly preferably 0. 5 mm, and/or
the thickness of the electrically insulating layer, preferably consisting of the oxide or nitride of the material of the substrate, is 10 nm to 1000 nm, preferably 50 nm to 300 nm, particularly preferably 200 nm, and/or
the thickness of the thermoelectric film (210; 310), preferably consisting of aluminum-doped zinc oxide, AZO, is 5 nm to 750 nm, preferably 10 nm to 90 nm, particularly preferably 30 nm, and/or wherein the metallic contacts (220, 230; 320-350; 720-790; 820-895; 1020-1060), preferably contain titanium, copper, aluminum, platinum, chromium and/or gold.

**16.** The method according to one of claims 13 to 15, further comprising:

applying a metallic ground contact to the thermoelectric film and connecting the ground contact to a ground line and/or
applying a thermoelectric resistor to the substrate and/or to the thermoelectric film.

Fig. 1

Fig. 2

Fig. 3

Fig. 4

Fig. 5

Fig. 6

Fig. 7

a)

b)

**Fig. 8**

a)

b)

c)

**Fig. 9**

Fig. 10

**EUROPEAN SEARCH REPORT**

Application Number

EP 25 18 1368

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MA RUIHUA ET AL: "Short-wave infrared position-sensitive detector enabled by lateral diffusion of thermalized carriers in lead salts", APPLIED PHYSICS LETTERS, AMERICAN INSTITUTE OF PHYSICS, 2 HUNTINGTON QUADRANGLE, MELVILLE, NY 11747, vol. 123, no. 11, 12 September 2023 (2023-09-12), XP012277721, ISSN: 0003-6951, DOI: 10.1063/5.0164229 [retrieved on 2023-09-12] * figures 1, 2, 3, 4 * * p. 2, col. 1 * & Ma Ruihua: "Supplementary Materials for Short-wave infrared position-sensitive-detector enabled by lateral diffusion of thermalized carriers in lead salts", , 12 September 2023 (2023-09-12), XP093326110, Retrieved from the Internet: URL:https://pubs.aip.org/aip/apl/article/123/11/112108/2910872/Short-wave-infrared-position-sensitive-detector * figure S2 * * p. 9 "Device fabrication" * ----- | 1-10, 13-16 | INV. G01J5/12 |
| X | US 9 343 647 B2 (KIRIHARA AKIHIRO [JP]; ENDOH HIROYUKI [JP] ET AL.) 17 May 2016 (2016-05-17) * figures 1, 3, 4, 8 * * col. 9, "Example 1" * * col. 8, l. 11-19 * * col. 6, second to last paragraph * ----- | 1-16 | |

TECHNICAL FIELDS SEARCHED (IPC)

G01J

The present search report has been drawn up for all claims

| Place of search | Date of completion of the search | Examiner |
|---|---|---|
| Munich | 17 October 2025 | Parise, Berengere |

EPO FORM 1503 03.82 (P4C01)

## ANNEX TO THE EUROPEAN SEARCH REPORT
## ON EUROPEAN PATENT APPLICATION NO.

EP 25 18 1368

This annex lists the patent family members relating to the patent documents cited in the above-mentioned European search report.
The members are as contained in the European Patent Office EDP file on
The European Patent Office is in no way liable for these particulars which are merely given for the purpose of information.

17-10-2025

| Patent document cited in search report | | Publication date | Patent family member(s) | Publication date |
|---|---|---|---|---|
| US 9343647 | B2 | 17-05-2016 | JP      5828341 B2 | 02-12-2015 |
| | | | JP WO2012153642 A1 | 31-07-2014 |
| | | | US    2014048115 A1 | 20-02-2014 |
| | | | WO    2012153642 A1 | 15-11-2012 |

For more details about this annex : see Official Journal of the European Patent Office, No. 12/82